# EUROPEAN PATENT SPECIFICATION

(11) **EP 0 493 797 B1**
(45) Date of publication and mention of the grant of the patent: **26.04.1995**
(21) Application number: 91122243.8
(22) Date of filing: 27.12.1991
(51) Int. Cl.: H01L 29/772, H01L 29/76

(54) **GaAs heterostructure metal-insulator-semiconductor integrated circuit and method for its fabrication**
GaAs Heterostruktur Metall-Isolator-Halbleiter integrierte Schaltung und deren Herstellungsmethode
Circuit intégré métal-isolant-semiconducteur à hétérostructure de GaAs et sa méthode de fabrication

(30) Priority: 31.12.1990 US 636321
(43) Date of publication of application: 08.07.1992
(73) Proprietor: HONEYWELL INC., Minneapolis Minnesota 55408 (US)
(72) Inventor: Childs, Timothy T., Dr., Minnetonka, MN 55343 (US); Nohava, Thomas E., Apple Valley, MN 55124 (US)
(74) Representative: Rentzsch, Heinz, Dipl.-Ing.

(56) References cited:
- PROC. IEEE/CORNELL CONF. ON ADVANCED CONCEPTS IN HIGH SPEED SEMICONDUCTOR DEVICES AND CIRCUITS (ITHACA, NY, US) 12 August 1987, pages 135 - 143 G.E.MENK ET AL. 'Microwave operation of heterostructure isolated-gate FETs'
- IEEE TRANSACTIONS ON ELECTRON DEVICES vol. 36, no. 10, October 1989, NEW YORK US pages 2236 - 2242 B.KIM ET AL. 'Millimeter-wave power operation of an AlGaAs/InGaAs/GaAs quantum well MISFET'
- IEEE TRANSACTIONS ON ELECTRON DEVICES vol. 36, no. 10, October 1989, NEW YORK US pages 2217 - 2222 M.HIRANO ET AL. 'Submicrometer n+ - Ge gate AlGaAs/GaAs MISFET's'

## Description

The invention pertains to heterostructure metal-insulator-semiconductor devices.

The related art consists of gallium arsenide (GaAs) doped channel heterostructure field effect transistor (DCHFET), complementary heterostructure field effect transistor (C-HIGFET) (with a high aluminum arsenide (AlAs) mole fraction) and metal oxide semiconductor field effect transistor (MOSFET) (without a molecular beam epitaxy (MBE) grown insulator) technologies. These technologies have the limitations of excessive gate leakage, low voltage swing, limited dynamic range and notable power consumption.

In an article "Microwave Operation of Heterostructure Isolated-Gate FETs" published in Proceedings IEEE/Cornell Conference on Advanced Concepts in High Speed Semiconductor Devices and Circuits (ITHACA, NY, USA), August 12, 1987, pgs. 135 - 143, G.E. Menk et al describe the fabrication of such devices by a refractory self-aligned gate process using undoped MBE-grown heterostructures employing an AlGaAs gate isolation layer. A planarization process with Au-based overlay metallization is used to reduce the gate resistance. The devices employ a two-dimensional elecron gas created at the undoped AlGaAs/GaAs interface under the gate electrode by the accumulation of free electrons from adjacent n+ regions self-aligned to the gate.

In another article "Millimeter-Wave Power Operation of an AlGaAs/InGaAs/GaAs Quantum Well MISFET" published in IEEE Transactions on Electron Devices, Vol. 36, No. 10, October 1989, New York, USA, pgs. 2236 - 2242, Bumman Kim et al refer to the development of millimeter-wave power transistors using quantum well MISFET's both with undoped InGaAs wells and doped InGaAs wells. A further article "Submicrometer n⁺-Ge Gate AlGaAs/GaAs MISFET's" published in IEEE Transactions on Electron Devices, Vol. 36, No. 10, October 1989, New York, USA, pgs. 2217 - 2220, M. Hirano et al report about the development of submicrometer n⁺-Ge gate AlGaAs/GaAs MISFET's by designing a fabrication process for the n⁺-implanted region. The short-channel effect was sufficiently suppressed by lowering ion-implantation energy down to 50 keV to achieve a standard deviation of threshold voltage as small as 13mV for 0.5-»m-gate FET's in a 2-in-diameter wafer. The source resistance was reduced by increasing the annealing temperature to 850°C to obtain a transconductance of 500 mS/mm for a 0.5-»m-gate FET. AlGaAs/GaAs MISFET's employ undoped GaAs as a channel and undoped AlGaAs as a gate insulator. The two-dimensional electron gas (2DEG) is induced at the AlGaAs/GaAs hetero-interface in the undoped GaAs when a gate voltage larger than the threshold voltage is applied. Since the channel layer of MISFET's is undoped, 2DEG can be transported with very high electron velocity due to the absence of impurity scattering.

The invention as characterized in the claims describes a new method and structure for attaining FET technology which provides lower gate leakage and greater voltage swings resulting in lower power consumption for digital applications and wider dynamic range for analog and microwave applications.

Fabrication of the present invention is simple and compatible with that of GaAs integrated circuit and monolithic microwave integrated circuit (MMIC) technologies. By insulating the gate with a dielectric the normal GaAs FET current leakage from the channel to the gate is virtually eliminated. This in turn results in the following enhancements:
a. Increase gate turn-on voltage > 5 volts.
b. Allow ± gate voltage.
c. Increase voltage swing, reduce power consumption for digital, analog and mimic circuits.

A thin Si/SiO₂ dielectric is used as the insulator. The insulated method and process is useful for MESFET, MODFET (HEMT), HIGFET and complementary HIGFET Integrated Circuit Technology.

### Brief Description of the Drawings

- Figure 1: reveals the basic structure of a GaAs heterostructure (H) metal-insulator-semiconductor (MIS) technology.
- Figure 2: shows an H-MIS field-effect transistor (FET).
- Figure 3: is a line drawing of an insulated gate of an H-MIS modulation-doped (MOD) FET.
- Figure 4: is a band diagram of a MIS-MODFET.
- Figure 5a: is a performance graph of a related art MODFET.
- Figure 5b: is a performance graph of a MODFET incorporating the present invention.
- Figure 6: is a schematic of a ring oscillator incorporating the present invention.

### Description of Preferred Embodiments

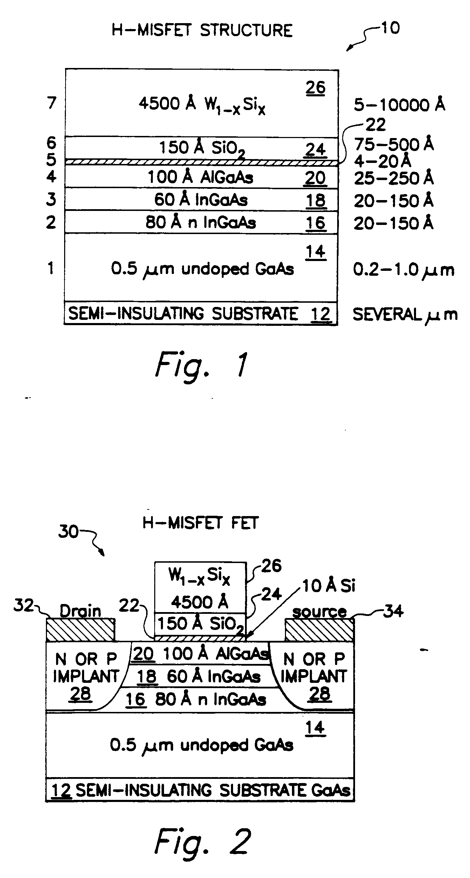

Figure 1 shows the sequence of layers 10 for H-MIS technology as applied for manufacturing a FET. On a semi-insulating GaAs wafer or substrate in a GaAs growth chamber (utilizing Molecular Beam Epilaxy MBE or Metal Organic Chemical Vapor Deposition MOCVD), a 0.5 »m buffer layer 14 of undoped GaAs is grown on substrate 12. Layer 14 may be at another thickness between 0.2 and 1.0 »m. Layer 12 typically is several »m thick. 8nm (80 angstroms) of an n doped InGaAs layer 16 is grown on layer 14. Layer 16 may be at another thickness between 2 and 15 nm (20 and 150 angstroms). 6nm (60 angstroms) of an undoped InGaAs layer 18 is grown on layer 16. Layer 18 may be at another thickness between 2 and 15nm (20 and 150 angstroms). A 10nm (100 angstrom) layer 20 of undoped AlGaAs is grown on layer 18. Layer 20 may be at another thickness between 2,5 and 25nm (25 and 250 angstroms). An interface of 2d electron gas results between layers 18 and 20 for fast mobility, as in the case of a MODFET. Then with wafer temperature structure 11 at about 300 degrees Celsius, insulator layer 22 is made by growing about 10 angstroms of silicon on layer 20, followed by the growth of about 15nm (150 angstroms) of lower stress SiO2 as insulator layer 24 on layer 22. Layer 22 may be at another thickness between 0,4 and 2,0nm (4 and 20 angstroms), and layer 24 may be at another thickness between 7,5 and 50nm (75 and 500 angstroms) . SiO2 layer 24 can alternatively be deposited ex-situ with a plasma enhanced chemical vapor deposition (PECVD) ratio of He/N2O/SiH4 flow rate of 4050/200/32 units in helium. The substrate temperature during Si layer 22 and SiO2 layer 24 growth, the thicknesses of Si layer 22 and SiO2 layer 24, and the low stress growth or deposition of SiO2 layer 24 are critical stages of the MIS-making process. Ultra thin layer 22 of Si epitaxially grown on AlGaAs layer 20 prevents the oxidation of GaAs while also providing a base for SiO2 insulator 24. The low defect Si/AlGaAs and Si/SiO2 interfaces between layers 22 and 20, and layers 22 and 24, respectively, reduce traps while allowing Si-SiO2 insulator 22 and 24 to virtually eliminate gate leakage of device 30. However, the thin layer 22 of Si turns into SiO2 when exposed or covered with SiO2.

On top of insulator layer 24, 450nm (4500 angstroms) of W₁₋ₓ Six, other metal silicide, as appropriate, as layer 26 is deposited for a gate. Layer 26 may be another thickness between 0,5 and 1000nm (5 and 10,000 angstroms). Interconnect metal may then be attached to layer 26. All of the thicknesses of structure 10 may be adjusted for optimization of device 30.

Layer 26 is covered by a mask to define the gate structure. Device 30 is made by etching layer 26 of W₁₋ₓ Six with CF4/O2 reactive ion etching (RIE). Layers 24 and 22 of SiO2 and Si are etched in a C2F6/CHF3 plasma. A standard self-aligned gate GaAs H-FET integrated circuit (IC) process (N, P or complementary) is performed. Specifically, an N or P implant is performed on layers 16, 18 and 20 N channel, resulting in an N channel or P channel FET, respectively. The N implant is of silicon ions and the P implant is of beryllium ions.

A lattice matched MIS surface, with the adhesiveness of dimmer arsenic, low stress SiO2 and Si-based gate metal, established a robust surface that can withstand the rapid optical anneal (ROA) steps on IC processing. N or P, as appropriate, ohmic contacts 32 and 34 are formed with Au:Ge based metallization. Metallization for two levels of interconnects for circuits are defined by lift-off.

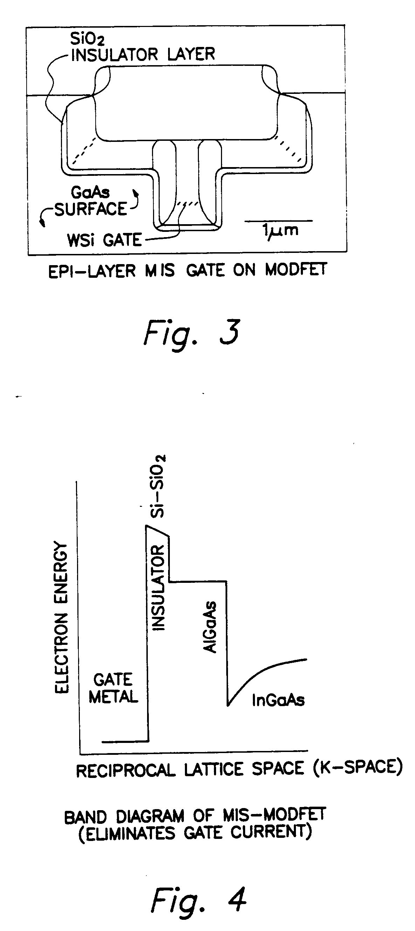

Figure 3 shows a line drawing of a magnified picture of an Epi-layer (epitaxy layer) MIS gate for a MODFET. Figure 4 is an energy band diagram of the MIS-MODFET, showing electron energy versus reciprocal lattice space (K-space). The diagram illustrates the basis for the elimination of gate current with the insulator layer.

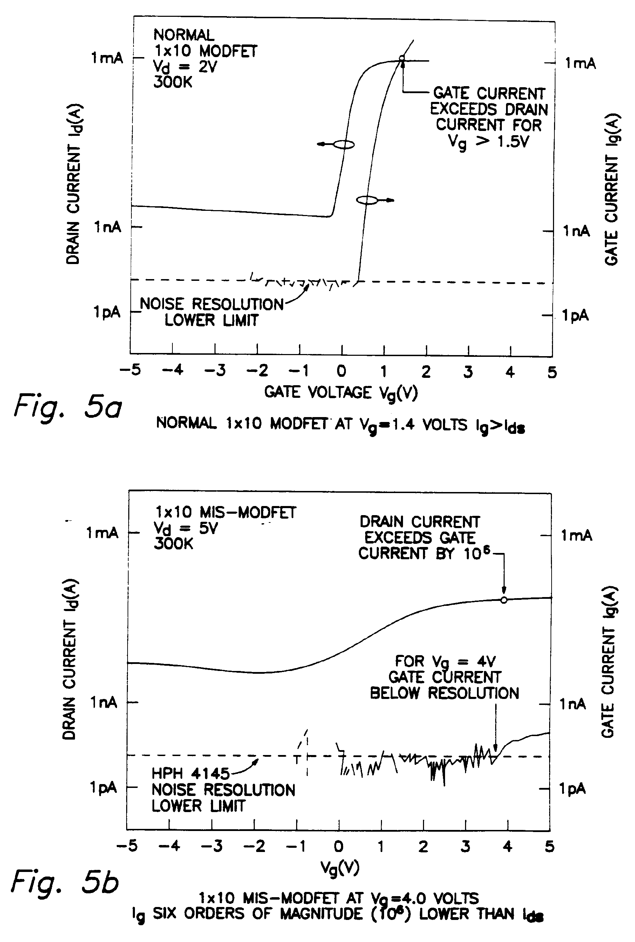

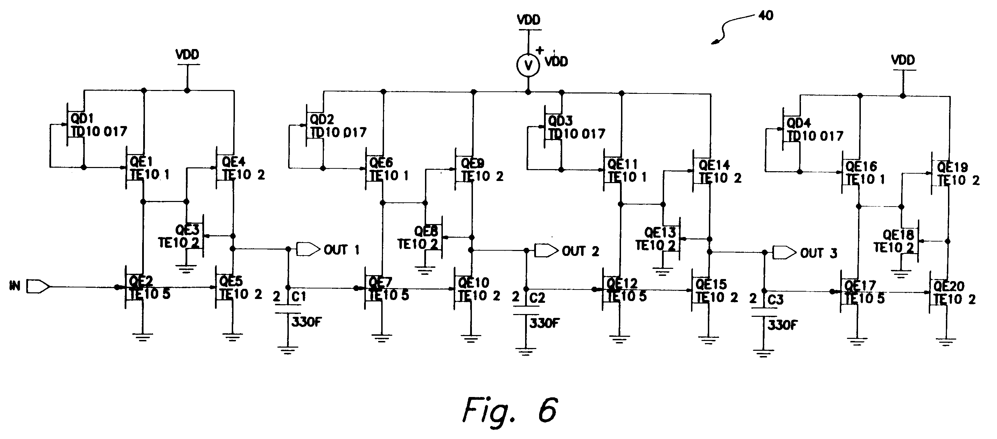

Figure 5 is a performance graph of a normal related-art 1 x 10 »m MODFET. Note that as the gate voltage approaches +1 volt the gate current greatly increases and the drain current reaches a maximum level. The gate current exceeds the drain current at gate voltages greater than +1.5 volts. Figure 6 is a performance graph, similar to Figure 5, for the present invention incorporated in a 1 x 10 micron MIS MODFET. In contrast, the drain current exceeds the gate current by 106 times at a gate voltage greater than 4 volts. The gate leakage is less than 10 picoamperes at a gate voltage of greater than 3 volts. The gate voltage tolerance with the present invention is from -15 to +15 volts. These performance specifications greatly exceed those of comparable related-art GaAs technologies.

The invention was incorporated into an enhanced/enhanced (E/E) logic FET feedback logic (FFL) 11-stage ring oscillator 40 shown in figure 6, having a fanout=1, fanin=1 and 1 millimeter of metal at each of the 11 stages. Testing showed the interconnect metal serpentines produced a capacitance of 0.33 picofarads at each stage for a total of 3.63 picofarads. At room temperature, the oscillator circuit yielded 31.0 MHz (i.e., 1.4 nanoseconds per gate) with a total current of 0.28 milliamperes. This translates to a power dissipation of 75 microwatts per gate. At a temperature of 170 degrees Celsius, the circuit yields 90 MHz (i.e., 520 picoseconds per gate. At 70 degrees Celsius, the power dissipation was less than 50 microwatts per gate. The circuit built and utilized was not designed for achieving a particular optimized speed or power dissipation but to demonstrate the feasibility of a functional large scale integrated (LSI) MISFET.

## Claims

1. A semiconductor comprising:
a) a substrate (12);
b) a layer (14) of undoped gallium arsenide GaAs on said substrate (12);
c) a layer (16) of n doped indium gallium arsenide InGaAs on said layer of undoped GaAs(14);
d) a layer (18) of undoped indium gallium arsenide InGaAs on said layer of n doped InGaAs (16);
e) a layer (20) of undoped aluminum gallium arsenide AlGaAs on said layer of undoped InGaAs (18);
f) a layer (22) of silicon Si on at least a portion of said layer of undoped AlGaAs (20);
g) a layer (24) of silicon dioxide SiO₂ on said layer of Si (22); and
h) a layer (26) of metal silicide on said layer of SiO₂ (24).

2. The semiconductor of claim 1, **characterized in that:**
a) the metal of said layer of metal silicide (26) is tungsten; and
b) said substrate (12) is of semi-insulating GaAs.

3. The semiconductor of claim 1 or 2, further comprising at least one ion implant (28) in said layers of undoped AlGaAs (20), undoped InGaAs (18) and n doped InGaAs (16).

4. The semiconductor of claim 3 further comprising an ohmic contact (32, 34) on said layer (20) of undoped AlGaAs in an area of said at least one ion implant (28).

5. The semiconductor according to one of the preceding claims, **characterized** **in that** said layers of metal silicide (26), SiO₂ (24) and Si (22) form a mesa on said layer of undoped AlGaAs (20).

6. The semiconductor according to one of the preceding claims, wherein:
a) said layer of metal silicide (26) has a thickness between 0,5 and 1000 nm;
b) said layer of SiO₂ (24) has a thickness between 7,5 and 50 nm;
c) said layer of Si (22) has a thickness between 0,4 and 2 nm;
d) said layer of undoped AlGaAs (20) has a thickness between 2,5 and 25 nm;
e) said layer of undoped InGaAs (18) has a thickness between 2,0 and 15 nm;
f) said layer of n doped InGaAs (16) has a thickness between 2,0 and 15 nm; and
g) said layer of undoped GaAs (14) has a thickness between 0.2 and 1.0 »m.

7. The semiconductor of claim 3 or 4, comprising:
a) a second ion implant in a second portion of said layers of aluminum gallium arsenide (20), undoped indium gallium arsenide (18), and n doped indium gallium arsenide (16); and
b) a second ohmic contact (32, 34) on said second implant (28).

8. The semiconductor according to one of the preceding claims, **characterized by** an interface of electron gas between said layer (18) of undoped indium gallium arsenide and said layer (20) of undoped aluminum gallium arsenide.

9. A method for making a semiconductor, comprising the steps of:
a) growing on a semi-insulating substrate (12) a first layer (14) of undoped GaAs, having a thickness between 0.2 and 1.0 »m;
b) growing a second layer (16) of n doped InGaAs, having a thickness between 2,0 and 15 nm, on said first layer (14);
c) growing a third layer (18) of undoped InGaAs, having a thickness between 2,0 and 15 nm, on said second layer (16);
d) growing a fourth layer (20) of undoped AlGaAs, having a thickness between 2,5 and 25 nm, on said third layer (18);
e) growing a fifth layer (22) of silicon, having a thickness between 0,4 and 2,0 nm, on said fourth layer (20);
f) growing a sixth layer (24) of silicon dioxide, having a thickness between 7,5 and 50 nm, on said fifth layer (22); and
g) growing a seventh layer (26) of metal silicide, having a thickness between 0,5 and 1000 nm, on said sixth layer (24).

10. The method ofclaim 9, **characterized by:**
a) masking a first area of said seventh layer (26), wherein said seventh (26), sixth (24) and fifth (22) layers each have congruent first and second areas; and
b) etching away the second areas of said seventh (26), sixth (24) and fifth (22) layers.

11. The method of claim 10, **characterized by:**
a) implanting ions through the second area of said fourth layer (20), into said fourth (20), third (18) and second (16) layers; and
b) forming first (32) and second (34) ohmic contacts on the second area of said fourth layer (20).

12. The method of claim 10 or 11, **characterized by** removing masking of the first area of said seventh layer (26).

13. The method according to one of the claims 9 to 12, **characterized by:**
a) heating the stack (11) including said first (14) to fourth (20) layers to approximately 300 degrees Celsius;
b) growing about 0,4 to 2,0 nm of silicon (22) on the layer of undoped AlGaAs (20), which becomes SiO₂ through exposure to oxygen; and
c) growing said 7,5 to 50 nm layer (24) of SiO₂ on the layer of silicon (22) which becomes SiO₂, to form an insulator in conjunction with the layer of SiO₂ (24).

14. The method of claim 13 comprising the following steps after masking the layer of metal silicide (26):
a) etching a mesa from the layer of metal silicide (26) with reactive ion etching;
b) etching the layer of SiO₂ (24) to continue the mesa from the layer of metal silicide (26), with a plasma;
c) etching the layer of Si (22) to continue the mesa from the layer of SiO₂ (24);
d) creating a plurality of ion implanted volumes (28) in the layer of undoped AlGaAs (20), in the layer of undoped InGaAs (18) and in the layer of n doped InGaAs (16); and
e) forming ohmic contacts (32, 34) on the implanted volumes (28) on the layer of AlGaAs (20).

15. The method according to one of the claims 11 to 14, **characterized in** **that**:
a) the first area of said seventh layer (26) provides connection for a base electrode of said semiconductor;
b) the first ohmic contact (32) provides connection for a drain electrode of said semiconductor; and
c) the second ohmic contact (34) provides connection for a source electrode of said semiconductor.

## Patentansprüche

1. Halbleiter mit:
a) einem Substrat (12);
b) einer Schicht (14) undotierten Galliumarsenids GaAs auf dem Substrat (12);
c) einer Schicht (16) von n-dotiertem Indium-Gallium-Arsenid InGaAs auf der Schicht undotierten GaAs (14);
d) einer Schicht (18) undotierten Indium-Gallium-Arsenids InGaAs auf der Schicht n-dotierten InGaAs (16);
e) einer Schicht (20) aus undotiertem Aluminium-Gallium-Arsenid AlGaAs auf der Schicht undotierten InGaAs (18);
f) einer Schicht (22) aus Silizium Si auf wenigstens einem Teil der Schicht aus undotiertem AlGaAs (20);
g) einer Schicht (24) aus Siliziumdioxyd SiO₂ auf der Schicht aus Si (22); sowie
h) einer Schicht (26) aus Metallsilizid auf der Schicht aus SiO₂ (24).

2. Halbleiter nach Anspruch 1, **dadurch gekennzeichnet,** daß
a) das Metall der Schicht aus Metallsilizid (26) Wolfram ist; und
b) das Substrat (12) aus halbisolierendem GaAs besteht.

3. Halbleiter nach Anspruch 1 oder 2, der weiterhin wenigstens ein Ionenimplantat (28) in den Schichten aus undotiertem AlGaAs (20), undotiertem InGaAs (18) und n-dotiertem InGaAs (16) aufweist.

4. Halbleiter nach Anspruch 3, der ferner einen Ohm'schen Kontakt (32, 34) auf der Schicht (20) aus undotiertem AlGaAs (20) im Bereich des wenigstens einen Ionenimplantats (28) aufweist.

5. Halbleiter nach einem der vorangehenden Ansprüche, **dadurch gekennzeichnet,** daß die Schichten aus Metallsilizid (26), SiO₂ (24) und Si (22) eine flache Fläche (Mesa) auf der Schicht aus undotiertem AlGaAs (20) bilden.

6. Halbleiter nach einem der vorangehenden Ansprüche, bei dem
a) die Schicht aus Metallsilizid (26) eine Dicke zwischen 0,5 und 1000 nm hat;
b) die Schicht aus SiO₂ (24) eine Dicke zwischen 7,5 und 50 nm aufweist;
c) die Siliziumschicht (22) eine Dicke zwischen 0,4 und 2 nm hat;
d) die Schicht aus undotiertem AlGaAs (20) eine Dicke zwischen 2,5 und 25 nm aufweist;
e) die Schicht aus undotiertem InGaAs (18) eine Dicke zwischen 2,0 und 15 nm hat;
f) die Schicht aus n-dotiertem InGaAs (16) eine Dicke zwischen 2,0 und 15 nm hat; und
g) die Schicht aus undotiertem GaAs (14) eine Dicke zwischen 0,2 und 1,0»m hat.

7. Halbleiter nach Anspruch 3 oder 4 mit:
a) einem zweiten Ionenimplantat in einem zweiten Teil der Schichten aus Aluminium-Gallium-Arsenid (20), undotiertem Indium-Gallium-Arsenid (18) und n-dotiertem Indium-Gallium-Arsenid (16); sowie
b) einem zweiten Ohm'schen Kontakt (32, 34) auf dem zweiten Implantat (28).

8. Halbleiter nach einem der vorangehenden Ansprüche, **gekennzeichnet durch** eine Zwischenlage aus Elektronengas zwischen der Schicht (18) aus undotiertem Indium-Gallium-Arsenid und der Schicht (20) aus undotiertem Aluminium-Gallium-Arsenid.

9. Verfahren zur Herstellung eines Halbleiters mit den Schritten:
a) Züchten einer ersten Schicht (14) aus undotiertem GaAs mit einer Dicke zwischen 0,2 und 1,0 »m auf einem Halbleitersubstrat (12);
b) Züchten einer zweiten Schicht (16) aus n-dotiertem InGaAs mit einer Dicke zwischen 2,0 und 15 nm auf der ersten Schicht (14);
c) Züchten einer dritten Schicht (18) aus undotiertem InGaAs mit einer Dicke zwischen 2,0 und 15 nm auf der zweiten Schicht (16);
d) Züchten einer vierten Schicht (20) aus undotiertem AlGaAs mit einer Dicke zwischen 2,5 und 25 nm auf der dritten Schicht (18);
e) Züchten einer fünften Schicht (22) aus Silizium mit einer Dicke zwischen 0,4 und 2,0 nm auf der vierten Schicht (20);
f) Züchten einer sechsten Schicht (24) aus Siliziumdioxyd mit einer Dicke zwischen 7,5 und 50 nm auf der fünften Schicht (22); sowie
g) Züchten einer siebenten Schicht (26) aus einem Metallsilizid mit einer Dicke zwischen 0,5 und 1000 nm auf der sechsten Schicht (24).

10. Verfahren nach Anspruch 9, **gekennzeichnet durch:**
a) Maskieren eines ersten Bereichs der siebenten Schicht (26), wobei die siebente (26), die sechste (24) und die fünfte Schicht (22) jeweils gleiche kongruente erste und zweite Bereiche haben; sowie
b) Abätzen der zweiten Bereiche der siebenten (26), der sechsten (24) und der fünften Schicht (22).

11. Verfahren nach Anspruch 10, **gekennzeichnet durch:**
a) Implantieren von Ionen durch den zweiten Bereich der vierten Schicht (20) in die vierte (20), die dritte (18) und die zweite Schicht (16); sowie
b) Bilden erster (32) und zweiter (34) Ohm'scher Kontakte auf dem zweiten Bereich der vierten Schicht (20).

12. Verfahren nach Anspruch 10 oder 11, **gekennzeichnet durch** Entfernen der Maskierung des ersten Bereichs der siebenten Schicht (26).

13. Verfahren nach einem der Ansprüche 9 bis 12, **gekennzeichnet durch:**
a) Aufheizen des Stapels (11) mit der ersten (14) bis vierten Schicht (20) auf etwa 300°C;
b) Züchten von 0,4 bis 2,0 nm Silizium (22) auf der Schicht undotierten AlGaAs (20), welches dadurch, daß man es Sauerstoffaussetzt, SiO₂ wird; und
c) Züchten der genannten 7,5 bis 50 nm Schicht (24) aus SiO₂ auf der Siliziumschicht (22), welche SiO₂ wird, um in Verbindung mit der Schicht aus SiO₂ (24) einen Isolator zu bilden.

14. Verfahren nach Anspruch 13 mit den folgenden Schritten nach der Maskierung der Schicht aus Metallsilizid (26);
a) Ätzen einer flachen Fläche (Mesa) aus der Schicht von Metallsilizid (26) durch reaktives Ionenätzen;
b) Ätzen der Schicht aus SiO₂ (24) mit einem Plasma, um das Mesa aus der Schicht von Metallsilizid (26) fortzusetzen;
c) Ätzen der Siliziumschicht (22), um das Mesa aus der Schicht von SiO₂ (24) fortzusetzen;
d) Erzeugen mehrerer ionenimplantierter Volumen (28) in der Schicht aus undotiertem AlGaAs (20), in der Schicht aus undotiertem InGaAs (18) und in der Schicht aus n-dotiertem InGaAs (16); sowie
e) Bilden Ohm'scher Kontakte (32, 34) auf den implantierten Volumen (28) auf der Schicht aus AlGaAs (20).

15. Verfahren nach einem der Ansprüche 11 bis 14, **dadurch gekennzeichnet,** daß :
a) der erste Bereich der siebenten Schicht (26) den Anschluß für eine Basiselektrode des Halbleiters;
b) der erste Ohm'sche Kontakt (32) den Anschluß für eine Senkenelektrode des Halbleiters; und
c) der zweite Ohm'sche Kontakt (34) den Anschluß für eine Quellenelektrode des Halbleiters bildet.

## Revendications

1. Semi-conducteur comportant :
a) un substrat (12);
b) une couche (14) d'arséniure de gallium GaAs non dopé sur ledit substrat (12);
c) une couche (16) d'arséniure de galliumindium InGaAs dopé n sur ladite couche de GaAs non dopé (14);
d) une couche (18) d'arséniure de galliumindium InGaAs non dopé sur ladite couche de InGaAs dopé n (16);
e) une couche (20) d'arséniure de galliumaluminium AlGaAs non dopé sur ladite couche de InGaAs non dopé (18);
f) une couche (22) de silicium Si sur au moins une partie de ladite couche de AlGaAs non dopé (20);
g) une couche (24) de dioxyde de silicium SiO₂ sur ladite couche de Si (22); et
h) une couche (26) de siliciure métallique sur ladite couche de SiO₂ (24).

2. Semi-conducteur selon la revendication 1, caractérisé en ce que :
a) le métal de ladite couche de siliciure métallique (26) est du tungstène; et
b) ledit substrat (12) est en GaAs semi-isolant.

3. Semi-conducteur selon la revendication 1 ou 2, comportant en outre au moins un implant ionique (28) dans lesdites couches de AlGaAs non dopé (20), de InGaAs non dopé (18) et de InGaAs dopé n (16).

4. Semi-conducteur selon la revendication 3, comportant en outre un contact ohmique (32, 34) sur ladite couche (20) de AlGaAs non dopé dans une zone dudit implant ionique (28).

5. Semi-conducteur selon l'une quelconque des revendications précédentes, caractérisé en ce que lesdites couches de siliciure métallique (26), de SiO₂ (24) et de Si (22) forment une table sur ladite couche de AlGaAs non dopé (20).

6. Semi-conducteur selon l'une quelconque des revendications précédentes, dans lequel :
a) ladite couche de siliciure métallique (26) a une épaisseur entre 0,5 et 1000 nm;
b) ladite couche de SiO₂ (24) a une épaisseur entre 7,5 et 50 nm;
c) ladite couche de Si (22) a une épaisseur entre 0,4 et 2 nm;
d) ladite couche de AlGaAs non dopé (20) a une épaisseur entre 2,5 et 25 nm;
e) ladite couche de InGaAs non dopé (18) a une épaisseur entre 2 et 15 nm;
f) ladite couche de InGaAs dopé n (16) a une épaisseur entre 2 et 15 nm; et
g) ladite couche de GaAs non dopé (14) a une épaisseur entre 0,2 et 1 »m.

7. Semi-conducteur selon la revendication 3 ou 4, comportant :
a) un deuxième implant ionique dans une deuxième partie desdites couches d'arséniure de gallium-aluminium (20), d'arséniure de gallium-indium non dopé (18) et d'arséniure de gallium-indium dopé n (16); et
b) un deuxième contact ohmique (32, 34) sur ledit deuxième implant (28).

8. Semi-conducteur selon l'une quelconque des revendications précédentes, caractérisé par une interface de gaz électronique entre ladite couche (18) d'arséniure de gallium-indium non dopé et ladite couche (20) d'arséniure de gallium-aluminium non dopé.

9. Procédé de fabrication d'un semi-conducteur, comportant les étapes consistant à :
a) faire croître sur un substrat semi-isolant (12) une première couche (14) de GaAs non dopé ayant une épaisseur entre 0,2 et 1 »m;
b) faire croître sur ladite première couche (14) une deuxième couche (16) de InGaAs dopé n ayant une épaisseur entre 2 et 15 nm;
c) faire croître sur ladite deuxième couche (16) une troisième couche (18) de InGaAs non dopé ayant une épaisseur entre 2 et 15 nm;
d) faire croître sur ladite troisième couche (18) une quatrième couche (20) de AlGaAs non dopé ayant une épaisseur entre 2,5 et 25 nm;
e) faire croître sur ladite quatrième couche (20) une cinquième couche (22) de silicium ayant une épaisseur entre 0,4 et 2 nm;
f) faire croître sur ladite cinquième couche (22) une sixième couche (24) de dioxyde de silicium ayant une épaisseur entre 7,5 et 50 nm; et
g) faire croître sur ladite sixième couche (24) une septième couche (26) de siliciure métallique ayant une épaisseur entre 0,5 et 1000 nm.

10. Procédé selon la revendication 9, caractérisé par le fait de :
a) masquer une première zone de ladite septième couche (26), dans laquelle lesdites septième (26), sixième (24) et cinquième (22) couches ont chacune des premières et deuxièmes zones qui coïncident; et
b) enlever par gravure les deuxièmes zones desdites septième (26), sixième (24) et cinquième (22) couches.

11. Procédé selon la revendication 10, caractérisé par le fait de :
a) implanter des ions à travers la deuxième zone de ladite quatrième couche (20), dans lesdites quatrième (20), troisième (18) et deuxième (16) couches; et
b) former des premier (32) et deuxième (34) contacts ohmiques sur la deuxième zone de ladite quatrième couche (20).

12. Procédé selon la revendication 10 ou 11, caractérisé par le fait d'enlever le masque de la première zone de ladite septième couche (26).

13. Procédé selon l'une quelconque des revendications 9 à 12, caractérisé par le fait de :
a) chauffer la pile (11) comprenant lesdites première (14) à quatrième (20) couches à approximativement 300 degrés Celsius;
b) faire croître environ 0,4 à 2 nm de silicium (22) sur la couche de AlGaAs non dopé (20), qui devient du SiO₂ par exposition à l'oxygène; et
c) faire croître une couche (24) de SiO₂ de 7,5 à 50 nm sur la couche de silicium (22) qui devient du SiO₂, afin de former un isolant en liaison avec la couche de SiO₂ (24).

14. Procédé selon la revendication 13, comportant les étapes suivantes, après masquage de la couche de siliciure métallique (26), consistant à :
a) graver une table à partir de la couche de siliciure métallique (26) par gravure ionique réactive;
b) graver avec un plasma la couche de SiO₂ (24) afin de continuer la table depuis la couche de siliciure métallique (26);
c) graver la couche de Si (22) afin de continuer la table depuis la couche de SiO₂ (24);
d) créer plusieurs volumes à implantation ionique (28) dans la couche de AlGaAs non dopé (20), dans la couche de InGaAs non dopé (18) et dans la couche de InGaAs dopé n (16); et
e) former des contacts ohmiques (32, 34) sur les volumes implantés (28) sur la couche de AlGaAs (20).

15. Procédé selon l'une quelconque des revendications 11 à 14, caractérisé en ce que :
a) la première zone de ladite septième couche (26) procure une connexion pour une électrode de base dudit semi-conducteur;
b) le premier contact ohmique (32) procure une connexion pour une électrode de drain dudit semi-conducteur; et
c) le deuxième contact ohmique (34) procure une connexion pour une électrode de source dudit semi-conducteur.
